Europäisches Patentamt

European Patent Office

Office européen des brevets

(11) Veröffentlichungsnummer: **0 317 776 B1**

(12) **EUROPÄISCHE PATENTSCHRIFT**

(45) Veröffentlichungstag der Patentschrift: **15.03.95**

(51) Int. Cl.⁶: **G01D 5/244**, H03M 1/00

(21) Anmeldenummer: **88117789.3**

(22) Anmeldetag: **26.10.88**

(54) **Positionsmesseinrichtung mit Unterteilungsschaltung.**

(30) Priorität: **13.11.87 DE 3738546**

(43) Veröffentlichungstag der Anmeldung:
**31.05.89 Patentblatt 89/22**

(45) Bekanntmachung des Hinweises auf die
Patenterteilung:
**15.03.95 Patentblatt 95/11**

(84) Benannte Vertragsstaaten:
**AT CH DE FR GB IT LI**

(56) Entgegenhaltungen:
DE-A- 2 431 630      DE-A- 3 107 938
DE-A- 3 126 047      DE-A- 3 218 101
DE-A- 3 510 651      US-A- 4 593 194

(73) Patentinhaber: **Dr. Johannes Heidenhain GmbH**
**Postfach 12 60**
**D-83292 Traunreut (DE)**

(72) Erfinder: **Ernst, Alfons, Dipl.-Ing.**
**Traunring 62**
**D-8225 Traunreut (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf eine Positionsmeßeinrichtung zur Ermittlung eines Winkels oder Weges mit einer Unterteilschaltung für zueinander phasen verschobene Signale, die durch Abtastung einer inkrementalen Maßverkörperung mittels einer Abtasteinrichtung gewonnen werden, die wenigstens einer Lichtsender und zwei Fotodetektoren aufweist.

Die Auflösung von inkrementalen Positionsmeßeinrichtungen ist ohne weitere elektronische Unterteilung zunächst nur 1/4 der Teilungsperiode, da von zwei um 90° zueinander versetzten Fotodetektoren der Abtasteinheit zwei entsprechend zueinander phasenverschobene Signale erzeugt werden, die vier Nulldurchgänge zum Erzeugen von Zählimpulsen aufweisen. Besitzen die beiden Signale eine genügend gute Sinusform, lassen sie sich zwischen den Nulldurchgängen auf verschiedene Weise elektrisch interpolieren.

Aus der DE-A- 35 10 651 ist eine Unterteilungsschaltung für einen inkrementalen Weggeber bekannt. Aus zwei um 90° zueinander phasenverschobenen Abtastsignalen werden die invertierten Abtastsignale gebildet, so daß vier jeweils um 90° zueinander phasenverschobene Signale entstehen. Die Abtastperiode wird in vier gleiche Abschnitte unterteilt. Das in jedem Abschnitt jeweils ungefähr linear ansteigende Signal dient zur Unterteilung des Inkrements.

Für das nachstehende Beispiel sei ferner die CH-PS 407 569 genannt.

Eine Möglichkeit zur elektronischen Meßwertinterpolation ist die Erzeugung von zusätzlichen Hilfsphasen in einem Widerstandsnetzwerk. Die mathematische Grundlage dafür bietet das Additionstheorem. Wählt man die Amplituden der beiden Signale

$$U1 = A1 \sin (2\pi X/C)$$

und

$$U2 = A2 \cos (2\pi X/C)$$

wobei C = Signalperiode
so, daß

$$A1 = \cos \phi$$

und

$$A2 = \sin \phi,$$

ergibt sich durch Addition der beiden Signale ein neues Signal

$$U = \sin (\phi + 2\pi X/C)$$

das zu U1 um $\phi$ phasenverschoben ist. X ist der Weg oder der Winkel und $\phi$ eine Hilfsgröße, die entsprechend dem geforderten Interpolationsgrad gewählt wird.

In modernen Auswerteelektroniken werden auf diese Weise bis zu 25fach-phasenverschobene Signale erzeugt und somit Auflösungen des Meßsystems bis zu 1/100 der Maßstabteilungsperiode erreicht.

Für noch höhere Unterteilungen eignen sich wegen des dann geringeren Schaltungsaufwandes besser Auswerteelektroniken mit Arcus-Tangens-Rechner, die Interpolationswerte zwischen zwei Perioden aus dem Arcus-Tangens des Quotienten der beiden Signale U1 und U2 ermitteln. Denn, wenn die Amplituden A1 und A2 der beiden Signale U1 und U2 gleich groß und konstant sind, gilt

$$\frac{U1}{U2} = \frac{A1 \sin (2\pi X/C)}{A1 \cos (2\pi X/C)} = \tan (2\pi X/C)$$

also

$$X = \frac{C}{2\pi} \cdot \arctan \frac{U1}{U2}$$

Die Quotientenbildung erfordert allerdings - bei den heute für Divisionsvorgänge zur Verfügung stehenden Bauelementen - verhältnismäßig viel Zeit, so daß sich die Laufzeiten erhöhen.

Die maximale Abtastfrequenz beträgt bei einer 25fach-Interpolation mit einem Widerstandsnetzwerk etwa 15 kHz, mit einer Arcus-Tangens-Interpolation etwa 50 kHz. Doch ergeben sich mit dem Arcus-Tangens-Rechner größere Laufzeiten von max. 1 ms gegenüber etwa $3\mu s$ beim Widerstandsnetzwerk.

Aus der US-PS 3,618,073 ist es darüber hinaus bekannt, Interpolationswerte aus einem Speicher zu entnehmen, der eine Arcus-Tangens-Tabelle enthält.

Die DE 31 07 938 A1 zeigt eine Vorrichtung zur Drehzahlmessung, die eine Unterteilungsschaltung für zueinander phasenverschobene Signale aufweist. Diese Signale werden mittels eines Lichtsenders und zwei Fotodetektoren durch Abtastung einer inkrementalen Maßverkörperung gewonnen und einer Schalteinheit zugeführt. Die Schalteinheit weist eine Logikschaltung auf, mittels der aus den eingehenden Abtastsignalen und invertierten Abtastsignalen jeweils eines der genannten Abtastsignale ausgewählt wird. Auf diese Weise wird ein sägezahnförmiges Signal als Winkelmeßsignal erzeugt, aus welchem der Winkelmeßwert rechnerisch ermittelt werden kann.

Aus der DE 32 18 101 A1 ist ein digitaler Inkrementalgeber mit einer Unterteilungsschaltung für analoge periodische Signale bekannt, die durch Abtastung einer inkrementalen Teilung mittels einer Abtasteinrichtung gewonnen werden. Eine Erhöhung der Auflösung erfolgt dabei durch Verknüpfung linearer Anteile der sinus- bzw. cosinusförmigen Signale.

Aus der DE 24 31 630 A1 ist ein optoelektronischer Aufnehmer zur Entfernungsmessung bekannt geworden, der von einem Tastkörper mit einer Lichtquelle und einer Referenzfläche gebildet ist. In der Stirnfläche des Teilungskörpers ist zudem ein lichtempfindliches Empfängerelement angeordnet, das die Lichtquelle so regelt, daß am lichtempfindlichen Regelelement ein konstanter Fotostrom fließt. Mit dieser Regelung der Lichtquelle sollen Schwankungen des Lichterzeugungsgrades und Änderungen im Trans- und Remissionsvermögen kompensiert werden, die eine Verfälschung des Meßergebnisses nach sich ziehen würden.

Der Erfindung liegt die Aufgabe zugrunde, bei einer Positionsmeßeinrichtung mit Unterteilungsschaltung die Laufzeit gering zu halten, um eine hohe Abtastfrequenz bei gleichzeitig hoher Unterteilung und geringem Bauelementeaufwand zu ermöglichen.

Diese Aufgabe wird von einer Positionsmeßeinrichtung mit den Merkmalen des Anspruches 1 gelöst.

Mit den in den abhängigen Ansprüchen angegebenen Merkmalen kann die Positionsmeßeinrichtung in besonders vorteilhafter Weise ausgestaltet werden.

Die besonderen Vorteile der Erfindung liegen darin, daß die Quotientenbildung aus den beiden Abastsignalen sowie der Speicher für die Arcus-Tangens-Tabelle entfallen kann.

Anhand eines Ausführungsbeispieles wird die Erfindung nachstehend mit Hilfe der Zeichnungen noch näher erläutert.

Es zeigt:

Figur 1    eine schematische Positionsmeßeinrichtung mit Unterteilungsschaltung;
Figur 2    ein Signaldiagramm;
Figur 3    ein weiteres Signaldiagramm.

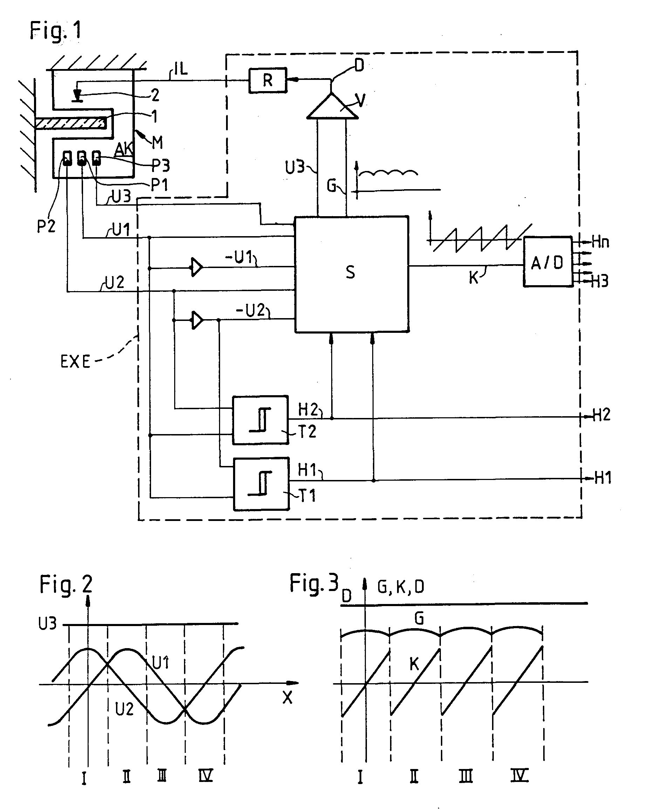

In Figur 1 ist eine Positionsmeßeinrichtung M dargestellt, bei der durch Abtastung einer Maßverkörperung 1 mittels eines Lichtsenders 2 und zwei Fotodetektorpaaren P1 und P2 zwei Abtastsignale U1 und U2 erzeugt werden. Wie aus Figur 2 ersichtlich ist, gilt:

$$U1 = A \sin (X \cdot 2\pi/C)$$
$$U2 = A \cos (X \cdot 2\pi/C)$$

Ein dritter Fotodetektor P3 liefert ein nicht moduliertes, nicht winkel- oder wegabhängiges Signal U3, das proportional zur Amplitude A der Abtastsignale U1 und U2 ist:

$$U3 \sim A$$

Die Abtastsignale U1 und U2 werden zusammen mit daraus abgeleiteten Signalen umgekehrten Vorzeichens -U1 und -U2 einer Schalteinheit S zugeführt.

3

Ferner werden die Signale U1 und -U2 einem Wandler-Baustein T1 zugeführt, der daraus einen binären Code H1 bildet. Die Signale U1 und U2 werden zusätzlich einem weiteren Wandler-Baustein T2 zugeführt, der daraus einen weiteren binären Code H2 bildet. Die beiden Codes H1 und H2 werden durch Triggerung aus den entsprechenden Abtastsignalen gebildet und über weitere Eingänge der Schalteinheit S zugeführt, in der sie zusammen mit den Abtastsignalen U1 und U2 und den Signalen -U1, -U2 weiter verarbeitet werden.

Bei der Weiterverarbeitung geht man davon aus, daß mit Hilfe der beiden Codes H1 und H2 vier Abschnitte - nämlich Abschnitt I(-45° bis 45°), Abschnitt II (45° bis 135°), Abschnitt III (135° bis 225°) und Abschnitt IV (225° bis 315°) - einer Signalperiode bestimmt werden.

In der Schalteinheit S werden dann aus Abtastsignalen U1, U2, -U1 und -U2 mit Hilfe der logischen Zustände der beiden Codes H1 und H2 unter Berücksichtigung der vier Signalperioden-Abschnitte I, II, III und IV zwei Signale G und K entsprechend der Tabelle

|     | H1 | H2 | G   | K   |
| --- | -- | -- | --- | --- |
| I   | 0  | 1  | U2  | U1  |
| II  | 1  | 1  | U1  | -U2 |
| III | 1  | 0  | -U2 | -U1 |
| IV  | 0  | 0  | -U1 | U2  |

geschaltet. Das Signal U3 und das Signal G werden in einem Summierer V zu einem Signal D addiert entsprechend:

$$D = U3 + G$$

Das so gebildete Signal D wird einem Regler R zugeführt.

Der Regler R regelt den Strom JL des Lichtsenders 2 der Abtasteinrichtung AK so, daß D = constant.

Betrachtet man in Figur 3 den Bereich I, so gilt

$$G = U2, K = U1$$

und

$$D = U3 + U2$$

U3 ändert sich abhängig von Strom JL proportional zur Amplitude A der Signale U1 und U2:

$$U3 = B \cdot A \quad (B = \text{Proportionalitätsfaktor})$$

$$D = B \cdot A + A \cdot \cos(2\pi X/C)$$
$$= A(B + \cos(2\pi X/C))$$

Daraus ergibt sich für die variable Amplitude A:

$$A = \frac{D}{B + \cos(2\pi X/C)}$$

4

und für das Signal K

$$K = U1 = \frac{D \cdot \sin\,(2\pi X/C)}{B + \cos\,(2\pi X/C)}$$

Durch geeignete Wahl der Konstanten B erhält man eine weitestgehend lineare Kennlinie für K (X), zwischen

$$-\frac{C}{8} \leqq X \leqq \frac{C}{8}$$

z. B. für B = 1,91 ist

$$\frac{K}{K(\pi/4)} = \frac{X}{C/8} + \delta$$

und

$\delta < 2 \cdot 10^{-4}$ ($\delta$ = Linearitätsabweichung)

Für die Bereiche II, III und IV gilt sinngemäß das Gleiche.

Da K~X kann nach Umwandlung des Signals K in einen Digitalwert direkt am Ausgang eines Analog/Digitalwandlers A/D ein Codesignal H3 ... Hn abgenommen werden das die Zwischenwerte einer Signalperiode repräsentiert und zusammen mit den Codesignalen H1 und H2 den Codewert für die Interpolation einer Periode des Weges oder Winkels X angibt, also den Momentanwert darstellt.

Das Signal U3 kann in bekannter Weise auch aus den Abtastsignalen erzeugt werden.

Dabei geht man von Fotoelemente-Signalen U11, U12, U21 und U22 aus, für die man setzen kann:

U11 = A0 + A/2 sin (X • $2\pi$/C)
U12 = A0 - A/2 sin (X • $2\pi$/C)
U21 = A0 + A/2 cos (X • $2\pi$/C)
U22 = A0 - A/2 cos (X • $2\pi$/C)

woraus

U1 = U11 - U12 = A sin (X • $2\pi$/C)
U2 = U21 - U22 = A cos (X • $2\pi$/C)

sowie

U3 = U11 + U12 + U21 + U22 = 4 A0

die Ausgangssignale der Abtasteinrichtung AK ergeben.

**Patentansprüche**

1. Positionsmeßeinrichtung (M) zur Ermittlung eines Winkels oder Weges (X) mit einer Unterteilungsschaltung (EXE) für zueinander phasenverschobene Signale (U1, U2), die durch Abtastung einer inkrementalen Maßverkörperung (1) mittels einer Abtasteinrichtung (AK) gewonnen werden, die wenigstens einen Lichtsender (2) und zwei Fotodetektoren (P1, P2) aufweist, wobei die an den Fotodetektoren gewonnenen Abtastsignale (U1, U2), die invertierten Abtastsignale (-U1, -U2) sowie zwei in zwei Wandler-Bausteinen (T1, T2) aus den Abtastsignalen (U1, U2) und invertierten Abtastsignalen (-U1, -U2) gewonnene binäre Codesignale (H1, H2), mit deren Hilfe eine Periode der Abtastsignale (U1, U2) in vier gleiche, jeweils durch die logischen Zustände der Codesignale (H1, H2) definierte Abschnitte (I, II, III, IV) unterteilt wird, einer Schalteinheit (S) zugeführt werden, die aus den Abtastsignalen (U1, U2) und invertierten Abtastsignalen (-U1, -U2) unter Berücksichtigung der logischen Zustände der Codesignale (H1, H2) ein erstes Ausgangssignal (G), ein zweites Ausgangssignal (K) sowie ein Hilfs-Ausgangssignal (U3) bildet, wobei das Hilfs-Ausgangssignal (U3), welches zur Amplitude der Abtastsignale (U1, U2) proportional ist, und das erste Ausgangssignal (G), welches demjenigen Signal aus den Abtastsignalen (U1, U2) und invertierten Abtastsignalen (-U1, -U2) entspricht, das im durch die Codesignale (H1, H2) definierten Periodenabschnitt (I, II, III, IV) maximal ist, addiert werden und deren Summe als Steuersignal (D) einer Regelschaltung (R) für den Lichtsender (2) zugeführt und dieser so geregelt wird, daß das Steuersignal (D) konstant bleibt, so daß zwischen dem zweiten Ausgangssignal (K), welches demjenigen Signal aus den Abtastsignalen (U1, U2) und invertierten Abtastsignalen (-U1, -U2) entspricht, das im durch die Codesignale (H1, H2) definierten Periodenabschnitt (I, II, III, IV) ansteigt, und dem Winkel oder Weg (X) zwischen Abtasteinrichtung (AK) und Massverkörperung (1) ein linearer Zusammenhang besteht, und daß das zweite Ausgangssignal (K) nach Umwandlung in einem Analog/Digitalwandler (A/D) an dessen Ausgang als binärer Code (H3 bis Hn) ansteht, der Zwischenwerte einer Signalperiode repräsentiert und zusammen mit den Codesignalen (H1, H2) den Momentanwert für den Winkel oder Weg (X) innerhalb einer Periode der Abtastsignale (U1, U2) darstellt.

2. Positionsmeßeinrichtung nach Anspruch 1, dadurch gekennzeichnet, daß der erste Abschnitt (I) den Bereich von -45° bis 45°, der zweite Abschnitt (II) den Bereich von 45° bis 135°, der dritte Abschnitt (III) den Bereich von 135° bis 225° und der vierte Abschnitt (IV) den Bereich von 225 bis 315° bestimmt.

3. Positionsmeßeinrichtung nach Anspruch 1, dadurch gekennzeichnet, daß das Hilfs-Ausgangssignal (U3) mit Hilfe eines zusätzlichen Fotodetektors (P3) gebildet wird.

4. Positionsmeßeinrichtung nach Anspruch 1, dadurch gekennzeichnet, daß die Gewinnung der beiden Codesignale (H1, H2) durch zwei Trigger (T1, T2) erfolgt.

5. Positionsmeßeinrichtung nach Anspruch 4, dadurch gekennzeichnet, daß dem einen Trigger (T2) die Abtastsignale (U1, U2) und dem anderen Trigger (T1) ein Abtastsignal (U1) und das invertierte Signal des anderen Abtastsignals (-U2) zugeführt wird.

6. Positionsmeßeinrichtung nach Anspruch 5, dadurch gekennzeichnet, daß zur Gewinnung des ersten Codesignals (H1) dem ersten Trigger (T1) ein Abtastsignal (U1) und das invertierte Signal des anderen Abtastsignals (-U2) zugeführt wird.

7. Positionsmeßeinrichtung nach Anspruch 5, dadurch gekennzeichnet, daß zur Gewinnung des zweiten Codesignals (H2) dem zweiten Trigger (T2) die beiden Abtastsignale (U1, U2) zugeführt werden.

**Claims**

1. A position measuring device (M) for determining an angle or displacement (X), with an interpolation circuit (EXE) for signals (U1, U2) phase displaced relative to one another, which are derived by sensing an incremental measuring entity (1) by means of a sensing device (AK), which has at least one light emitter (2) and two photo-detectors (P1, P2), wherein there are applied to a switching unit (S) the sensing signals (U1, U2) derived from the photo-detectors, the inverted sensing signals (-U1, -U2) and two binary coded signals (H1, H2) derived in two converter units (T1, T2) from the sensing signals (U1, U2) and inverted sensing signals (-U1, -U2), with the aid of which a period of the sensing signals (U1, U2) is divided into four equal sections (I, II, III, IV) defined by the logical states of the coded signals (H1, H2), wherein the switching unit (S) forms from the sensing signals (U1, U2) and inverted sensing signals (-U1, -U2), having regard to the logical states of the coded signals (H1, H2), a first output signal (G), a second output signal (K) and an auxiliary output signal (U3), wherein the auxiliary output signal (U3), which is proportional to the amplitude of the sensing signals (U1, U2), and the first output signal (G) which corresponds to that signal of the sensing signals (U1, U2) and inverted sensing signals (-U1, -U2) which is maximum in the period section (I, II, III, IV) defined by the coded signals (H1, H2), are added and their sum is applied as a control signal (D) to a regulating circuit (R) for the light emitter (2) and this is so regulated that the control signal (D) remains constant, so that there is a linear relationship between the second output signal (K), which corresponds to that signal of the sensing signals (U1, U2) and inverted sensing signals (-U1, -U2) which is increasing in the period section (I, II, III, IV) defined by the coded signals (H1, H2), and the angle or displacement (X) between the sensing device (AK) and the measuring entity (1), and in that the second output signal (K) represents the intermediate value of a signal period after conversion in an analog/digital converter (A/D), at whose output it is present as binary codes (H3 to Hn), which represent, together with the coded signals (H1, H2),the instantaneous value of the angle or displacement (X) within a period of the sensing signals (U1, U2).

2. A position measuring device according to claim 1, characterized in that the first section (I) determines the range from -45° to 45°, the second section (II) the range from 45° to 135°, the third section (III) the range from 135° to 225° and the fourth section (IV) the range from 225° to 315°.

3. A position measuring device according to claim 1, characterized in that the auxiliary output signal (U3) is formed with the aid of an additional photo-detector (P3).

4. A position measuring device according to claim 1, characterized in that the derivation of the two coded signals (H1, H2) is effected by two trigger circuits (T1, T2).

5. A position measuring device according to claim 4, characterized in that the sensing signals (U1, U2) are applied to the one trigger circuit (T2) and one sensing signal (U1) and the inverted signal of the other sensing signal (-U2) are applied to the other trigger circuit (T1).

6. A position measuring device according to claim 5, characterized in that one sensing signal (U1) and the inverted signal of the other sensing signal (-U2) are applied to the first trigger circuit (T1) to derive the first coded signal (H1).

7. A position measuring device according to claim 5, characterized in that the two sensing signals (U1, U2) are applied to the second trigger circuit (T2) to derive the second coded signal (H2).

**Revendications**

1. Dispositif de mesure de position (M) pour déterminer un angle ou une course (X), comportant un circuit diviseur (EXE) pour des signaux (U1, U2) mutuellement déphasés qui sont obtenus par lecture d'une mesure matérialisée (1) incrémentale au moyen d'un dispositif de lecture (AK) comprenant au moins une source de lumière (2) et deux capteurs photo-électriques (P1, P2), les signaux de lecture (U1, U2) délivrés par les capteurs photo-électriques, les signaux de lecture (-U1, -U2) inversés ainsi que deux signaux de code (H1, H2) binaires qui sont formés dans deux modules convertisseurs (T1, T2) à partir des signaux de lecture (U1, U2) et des signaux de lecture (-U1, -U2) inversés et au moyen desquels une période des signaux de lecture (U1, U2) est divisée en quatre parties (I, II, II IV) identiques définies chacune par les états logiques des signaux de code (H1, H2) étant envoyés à une unité de commutation (S) qui, à partir des signaux de lecture (U1, U2) et des signaux de lecture inversés (-U1, -U2), en tenant compte des états logiques des signaux de code (H1, H2), forme un premier signal de sortie (G), un deuxième signal de sortie (K) et un signal de sortie auxiliaire (U3), le signal de sortie auxiliaire (U3) qui est proportionnel à l'amplitude des signaux de lecture (U1, U2) et le premier signal de sortie (G) qui correspond au signal formé à partir des signaux de lecture (U1, U2) et du signal qui, parmi les signaux de lecture inversés (-U1, -U2), est maximal dans la partie de période (I, II, III, IV) définie par les signaux de code (H1, H2) étant additionnés et leur somme étant envoyée, en tant que signal de commande (D), à un circuit de réglage (R) de la source de lumière (2), cette dernière étant réglée de telle sorte que le signal de commande (D) reste constant afin qu'il existe une relation linéaire entre le deuxième signal de sortie (K) qui correspond au signal qui, parmi les signaux de lecture (U1, U2) et des signaux de lecture inversés (-U1, -U2), augmente dans la partie (I, II, III, IV) définie par les signaux de code (H1, H2) et l'angle ou la course (X) entre le dispositif de lecture (Ak) et la mesure matérialisée (1), et que le deuxième signal de sortie (K), après transformation dans un convertisseur analogique/numérique (A/D) est disponible à la sortie de celui-ci sous forme de code (H3 à Hn) binaire qui représente des valeurs intermédiaires d'une période de signal et avec les signaux de code (H1, H2) représente la valeur instantanée pour l'angle ou la course (X) à l'intérieur d'une période des signaux de lecture (U1, U2).

2. Dispositif de mesure de position selon la revendication 1, caractérisé par le fait que la première partie (I) détermine la zone de -45° à 45°, la deuxième partie (II) la zone de 45° à 135°, la troisième partie (III) la zone de 135° à 225° et la quatrième partie (IV) la zone de 225° à 315°.

3. Dispositif de mesure de position selon la revendication 1, caractérisé par le fait que le signal de sortie auxiliaire (U3) est obtenu au moyen d'un capteur photo-électrique (P3) supplémentaire.

4. Dispositif de mesure de position selon la revendication 1, caractérisé par le fait que les deux signaux de code (H1, H2) sont obtenus au moyen de deux déclencheurs (T1, T2).

5. Dispositif de mesure de position selon la revendication 4, caractérisé par le fait que l'on envoie à l'un (T2) des déclencheurs les signaux de lecture (U1, U2) et à l'autre déclencheur (T1) un signal de lecture (U1) et le signal inversé de l'autre signal de lecture (-U2).

6. Dispositif de mesure de position selon la revendication 5, caractérisé par le fait que, pour obtenir le premier signal de code (H1), on envoie au premier déclencheur (T1) un signal de lecture (U1) et le signal inversé de l'autre signal de lecture (-U2).

7. Dispositif de mesure de position selon la revendication 5, caractérisé par le fait que pour obtenir le deuxième signal de code (H2) on envoie au deuxième déclencheur (T2) les deux signaux de lecture (U1, U2).

EP 0 317 776 B1

Fig. 1

Fig. 2

Fig. 3